# EUROPÄISCHE PATENTSCHRIFT

(11) **EP 2 817 836 B1**
(45) Veröffentlichungstag und Bekanntmachung des Hinweises auf die Patenterteilung: **13.04.2016**
(21) Anmeldenummer: 13705118.1
(22) Anmeldetag: 05.02.2013
(51) Int. Cl.: H01L 41/083, H01L 41/293

(54) **VIELSCHICHTBAUELEMENT UND VERFAHREN ZUM HERSTELLEN EINES VIELSCHICHTBAUELEMENTS**
MULTILAYER COMPONENT AND METHOD FOR PRODUCING A MULTILAYER COMPONENT
COMPOSANT MULTICOUCHE ET PROCÉDÉ DE PRODUCTION D'UN COMPOSANT MULTICOUCHE

(30) Priorität: 20.02.2012 DE 102012101351
(43) Veröffentlichungstag der Anmeldung: 31.12.2014
(73) Patentinhaber: Epcos AG, 81669 München (DE)
(72) Erfinder: SOMITSCH, Dieter, 8522 Groß St. Florian (AT); RINNER, Franz, 8530 Deutschlandsberg (DE)
(74) Vertreter: Epping - Hermann - Fischer
(86) Internationale Anmeldenummer: PCT/EP2013/052214
(87) Internationale Veröffentlichungsnummer: WO 2013/124146

(56) Entgegenhaltungen:
- WO-A2-2008/092740
- DE-A1-102006 011 293
- JP-A- 05 267 743
- JP-A- 2005 072 370
- US-A- 5 254 212

## Beschreibung

Die Erfindung betrifft ein vollaktives Vielschichtbauelement ein Verfahren zum Herstellen eines vollaktiven Stapels und ein Verfahren zum Herstellen eines vollaktiven Vielschichtbauelements aus dem vollaktiven Stapel.

Vielschichtbauelemente umfassen Kondensatoren und Piezoaktoren, die jeweils alternierende dielektrische Schichten und Innenelektroden enthalten. Im Falle der Piezoaktoren sind die dielektrischen Schichten zudem piezoelektrisch. Daher gehören Piezoaktoren zu den Piezoelementen.

Piezoelemente werden unter anderem für Positionierelemente, Ultraschallwandler, Sensoren und in Tintenstrahldruckern sowie in der Automobiltechnik verwendet.

Wird an das Piezoelement eine elektrische Spannung angelegt, so dehnt sich dieses in senkrechter Richtung zum erzeugten elektrischen Feld aus (inverser Piezo-Effekt).

Vorteile von Piezoelementen sind unter anderem deren relativ große Geschwindigkeit, deren relativ große Effektivität und, wenn als Piezoaktor verwendet, deren relativ kleiner Stellweg.

Soll jedoch mit dem Piezoaktor ein relativ großer Stellweg erreicht werden, dann wird für den Piezoaktor ein Piezostapel aus mehreren, abwechselnd aufeinander folgenden piezoelektrischen Schichten und Innenelektrodenschichten verwendet, wie dies z. B. in der JP 03174783 A oder der JP2005072370 offenbart ist.

Der in der JP 03174783 A offenbarte Piezoaktor ist derart ausgeführt, dass die Innenelektrodenschichten abwechselnd mit an gegenüber liegenden Außenflächen des Piezostapels angeordneten Außenelektroden elektrisch verbunden sind. Die Innenelektrodenschichten, die mit einer der beiden Außenelektroden elektrisch verbunden sind, sind daher bis zu der Außenseite, an der diese Außenelektrode angeordnet ist, für die elektrische Verbindung mit der Außenelektrode herangeführt. Damit die Innenelektrodenschichten jedoch von der anderen Außenelektrode elektrisch isoliert sind, reichen die Innenelektrodenschichten nicht bis zur Außenseite des Piezostapels heran, an der die weitere Außenelektrode angeordnet ist. In diesen Bereichen sind die Innenelektrodenschichten von der Außenseite zurückgesetzt. Dies wird erreicht, indem der Piezostapel in diesen Bereichen mit Silikonharz gefüllten Schlitzen versehen ist.

Durch die zurückgesetzten Innenelektrodenschichten ergeben sich in diesen Bereichen zugeordneten piezoelektrischen Schichten so genannte inaktive Zonen. Üblicherweise werden die inaktiven Zonen bei der schichtweisen Herstellung des Piezostapels erzeugt. Durch Toleranzen der Prozesse, Stapeln, Trennen, Entbindern und Schleifen während der Herstellung des Piezostapels mit inaktiven Zonen und aufgrund der Vorgabe einer zuverlässigen elektrischen Isolierung der Innenelektrodenschichten zur entsprechenden Außenelektrode ergeben sich relativ große inaktive Zonen von typischerweise bis zu 10 Prozent des Piezostapelquerschnitts. Die inaktiven Zonen, die bei einer an den Außenelektroden- beziehungsweise Innenelektrodenschichten angelegten elektrischen Spannung von einer reduzierten elektrischen Feldstärke durchsetzt werden und sich daher bei angelegter elektrischer Spannung weniger stark dehnen als die übrigen so genannten aktiven Zonen der Piezoelektrischen Schichten. Dies führt zu mechanischen Spannungen insbesondere in den inaktiven Zonen und den Randbereichen zu den inaktiven Zonen und kann zu so genannten Polungsrissen in den inaktiven und aktiven Zonen der Piezoelektrischen Schichten, sowie in den Außenelektroden führen. Die Gefahr von Polungsrissen ist umso größer, je größer die inaktiven Zonen sind.

Die Aufgaben der Erfindung sind, ein Vielschichtbauelement gemäss Anspruch 12 und ein Verfahren gemäss Anspruch 1 zu seiner Herstellung anzugeben, bei dem die Leistung im Betrieb verbessert ist. Insbesondere einen Piezoaktor zur Verfügung zu stellen, bei dem die mechanischen Spannungen in der Piezokeramik im Betrieb des Piezoaktors wesentlich verringert sind.

Unter einem vollaktiven Stapel ist erfindungsgemäß ein Stapel zu verstehen, bei dem die Innenelektroden durchgehend sind, d.h. sich über die gesamte Querschnittsfläche des Stapels erstrecken. Durch diese Ausgestaltung reichen die gesamten Innenelektroden bis an die Außenseite des Stapels, weshalb dieser keine inaktiven Zonen aufweist. Dadurch wird die Leistung des Vielschichtbauelements um Betrieb verbessert und im Fall des Piezoaktors die Höhe der mechanischen Spannungen in der Piezokeramik während des Betriebs verringert.

Der in dem Verfahren zur Herstellung eines vollaktiven Stapels bereitgestellte (Ausgangs)stapel wird beispielsweise durch alternierendes Stapeln von mindestens zwei Teilstapeln hergestellt, wobei jeder der Teilstapel eine dielektrische Schicht und eine darauf angeordnete Innenelektrodenschicht aufweist. Der bereitgestellte Stapel wird dabei insbesondere hergestellt, indem sogenannte grüne Keramikfolien beispielsweise im Siebdruckverfahren mit metallischen Pasten bedruckt werden. Das Bedrucken wird dabei so ausgeführt, dass die metallischen Pasten die keramische Grünfolie vollständig bedecken, wobei auf einer Seite ein unbedruckter Rand belassen wird. Die metallischen Pasten weisen z.B. AgPd- oder Cu-Partikel, Lösungsmittel und weitere Zusätze auf. Danach werden typischerweise ca. 300 bis 600 mit der Paste versehene grüne Keramikfolien aus den beiden Teilstapeln so übereinandergelegt, dass ein Block entsteht, in dem die metallischen Zwischenschichten zwei gegenüberliegende Seiten abwechselnd kontaktieren und jede zweite Zwischenschicht bezüglich des unbedruckten Randes identisch ausgerichtet ist. Der entstandene Stapel wird dann durch Pressen zu einem sogenannten Grünblock verarbeitet. Anschließend wird der Grünblock zur Entfernung von Lösungsmittelresten entbindert und gegebenenfalls gesintert. Aus einem Grünblock können durch Trennung in einzelne Stapel gegebenenfalls mehrere (Ausgangs)stapel bzw. -riegel erzeugt werden.

In dem Verfahren zur Herstellung eines vollaktiven Stapels oder dessen grünen Vorläufers kann der in dem ersten Schritt bereitgestellte (Ausgangs)stapel entweder gesintert oder grün sein. Wenn der Stapel gesintert ist, hat dies den Vorteil, dass die Gefahr einer Beeinträchtigung der keramischen Zwischenschichten in dem Piezostapel bei der Durchführung der elektrochemischen Beschichtung gering ist.

In einer erfindungsgemäßen Ausführungsform wird das elektrochemische Beschichten der elektrisch angesteuerten Innenelektroden auf den Seiten A und C mittels elektrochemischer Oxidation, vorzugsweise durch anodische Oxidation, durchgeführt. Unter anodischer Oxidation wird erfindungsgemäß ein elektrolytisches Verfahren zur Herstellung von oxidischen Schichten auf Metallen verstanden. Alternativ kann das elektrochemische Beschichten mittels Galvanotechnik bzw. Elektroplattieren erfolgen. Unter Galvanotechnik bzw. Elektroplattieren wird erfindungsgemäß die elektrochemische Abscheidung von metallischen Schichten auf Gegenständen verstanden.

In einer erfindungsgemäßen besonderen Ausführungsform werden vor dem elektrochemischen Beschichten alle Innenelektroden, vorzugsweise nach dem Prinzip des elektrochemischen Abtragens, zurückgeätzt. Unter elektrochemischen Abtragen wird erfindungsgemäß ein Verfahren zum Entfernen von Metall durch ein elektrochemisches Verfahren verstanden.

In einer besonderen erfindungsgemäßen Ausführungsform wird das elektrochemische Beschichtung in einer wässrigen NaCl-Lösung als Elektrolyt durchgeführt. Hierbei kann eine Wechselspannung, z. B. 50 HZ, verwendet werden. Die Innenelektroden bestehen hierzu vorzugsweise aus Silber oder einer Silberlegierung, weiter bevorzugt AgPd. Auf diese Weise wächst eine Silberoxidschicht auf den spannungsführenden Elektroden auf (vgl. BAEWA, W. "Oxidation von Silber durch Wechselstrom von 50 HZ in wässriger Natriumlösung" in Werkstoffe und Korrosion, Band 22, Ausgabe 2, Seiten 143 ff, Heft 2/1971).

Ausführungsbeispiele der Erfindung sind in den beigefügten schematischen Zeichnungen beispielhaft dargestellt. Es zeigen:
- Figur 1: eine perspektivische Seitenansicht eines Piezostapels mit den Seiten A, B, C und D entlang der Stapelrichtung,
- Figur 2: ein Elektrolysebad zum elektrochemischen Beschichten eines Piezostapels,
- Figuren 3A und 3B: die auf den Innenelektroden aufgebrachten Oxidschichten,
- Figur 4: einen vereinzelten vollaktiven Piezostapel mit den Seiten A', B', C' und D' entlang der Stapelrichtung,
- Figur 5A: einen Piezostapel mit aufgebrachter galavanischer Beschichtung über den elektrisch angesteuerten Innenelektroden,
- Figur 5B: einen Piezostapel mit zusätzlich aufgebrachtem Isolationsmaterial,
- Figur 5C: den Piezostapel nach einem weiteren Polierschritt, so dass die galvanische Beschichtung freigelegt ist,
- Figur 6A: einen Piezostapel mit zu Gräben zurückgeätzten Innenelektroden,
- Figur 6B: einen Piezostapel mit teilweise durch galvanische Beschichtung wieder aufgefüllten Gräben,
- Figur 6C: den zusätzlich mit Isolationsmaterial unter Auffüllung der übrigen Gräben beschichteten Piezostapel,
- Figur 6D: den Piezostapel nach einem zusätzlichen Polierschritt,
- Figur 6E: den schließlich mit einer Außenelektrode versehenen vollaktiven Piezostapel.

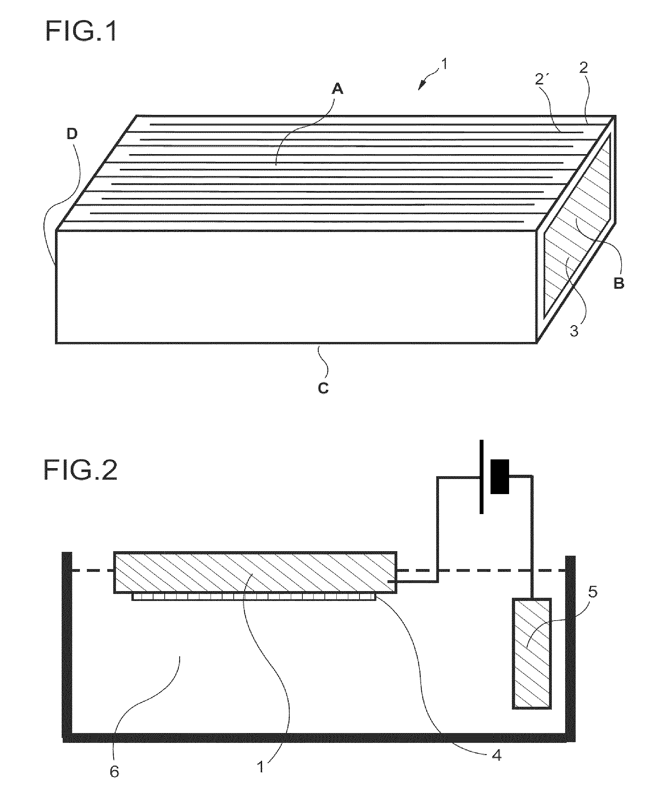

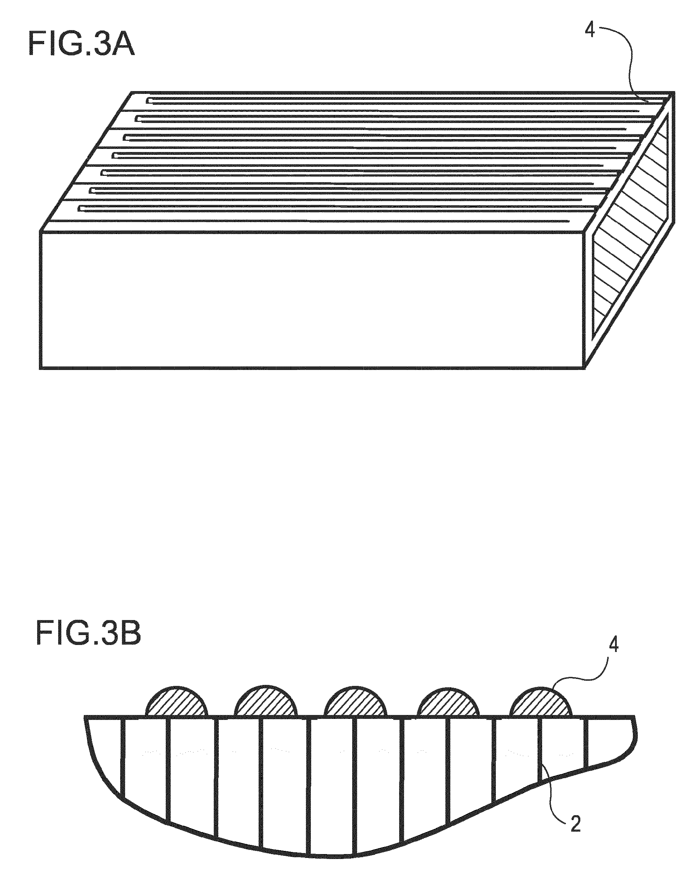

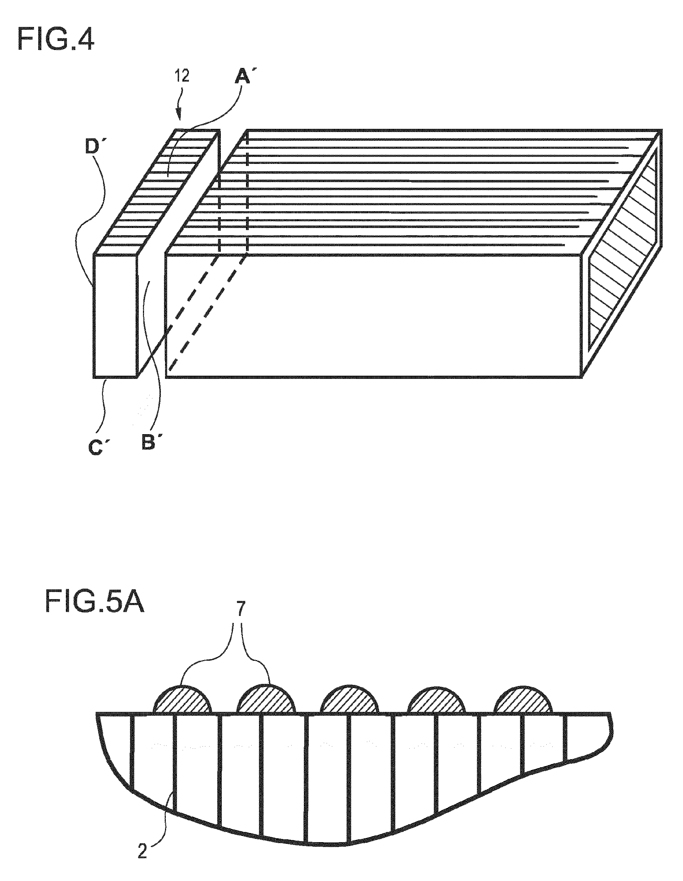

In einem ersten Ausführungsbeispiel ist der Prozessablauf wie folgt:
a) Es wird ein gesinterter Piezostapel (1) mit den Seiten A, B, C und D entlang der Stapelrichtung bereitgestellt. Der Piezostapel besitzt (temporäre) Isozonen und Außenkontaktierungen (3), so dass über die Außenkontaktierung (3) jede zweite Innenelektrode (2) auf der Seite B sowie über die entsprechende Außenkontaktierung (3', nicht gezeigt) auf der Seite D jede zweite Innenelektrode (2') elektrisch angesteuert werden kann (vgl. Figur 1).
b) Der Piezostapel (1) wird einseitig (Seite C) in eine Elektrolytlösung (6) getaucht (Figur 2), der Piezostapel (1) an der Außenkontaktierung (3) der Seite B unter (positive) Spannung gesetzt, die Gegenelektrode (5) auf negative Spannung, und ein paar Minuten bestromt. An den spannungsführenden Innenelektroden (2) des Piezostapels (1) bildet sich eine Oxidschicht (4) aus (vgl. Figur 2, Figur 3A und Figur 3B). Hierbei wird das Prinzip der anodischen Oxidation ausgenützt.
c) Der Verfahrensschritt b) wird für die Seite A des Piezostapels (1) in analoger Weise durchgeführt.
d) Der Piezostapel (1) mit den beschichteten Innenelektroden (2, 2') wird zu vollaktiven Piezostapeln (12) vereinzelt (Figur 4).
e) Auf den Seiten A' und C' werden durch Metallisierung mit Leitkleber oder Metallisierungspaste Außenelektroden (11) aufgebracht, die jeweils auf der entsprechenden Seite die nicht mit einer Oxidschicht versehenen Innenelektroden, d. h. Innenelektroden (2') auf Seite A' beziehungsweise Innenelektrode (2) auf Seite C', elektrisch kontaktieren.

Die Schritte d) und e) können auch in umgekehrter Reihenfolge prozessiert werden.

In einer Variante des ersten Ausführungsbeispiels wird eine wässrige NaCl-Lösung als Elektrolyt verwendet und eine elektrische Wechselspannung zwischen dem Piezostapel (1) über die durch die Außenkontaktierung (3) angesteuerten Innenelektroden (2) und der Gegenelektrode (5) angelegt. In dieser Variante bestehen die Innenelektroden aus Silber oder einer Silberlegierung, z. B. AgPd, wodurch eine Silberoxidschicht auf den spannungsführenden Elektroden aufwächst (vgl. BAEWA, W. "Oxidation von Silber durch Wechselstrom von 50 HZ in wässriger Natriumchlorid-Lösung" in Werkstoffe und Korrosion, Band 22, Ausgabe 2, Seiten 143 ff in Heft 2/1971).

In einer weiteren Variante des ersten Ausführungsbeispiels werden die zu beschichtenden Innenelektroden (2, 2') zuerst durch das Prinzip des elektrochemischen Abtragens 1 bis 10 µm, vorzugsweise 1 bis 5 µm, in die Tiefe abgetragen, wodurch elektrochemisch zurückgeätzte Gräben (9) entstehen. Anschließend wird gegebenenfalls durch Wechsel des Elektrolyts der Prozess der anodischen Oxidation durchgeführt. Hierdurch erhält man eine Oxidschicht, die weiter in die Bauteiltiefe geht und so eine bessere Isolierung gewährleistet.

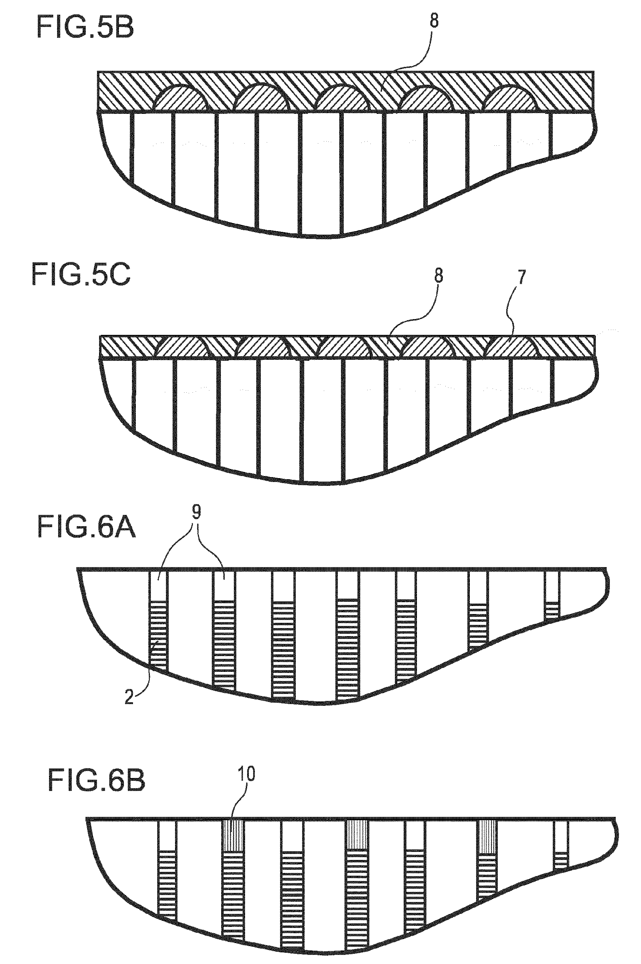

In einem zweiten Ausführungsbeispiel wird der Prozess wie folgt durchgeführt:
a) Es wird ein gesinterter Piezostapel (1) mit seitlichen (temporären) Isozonen und Außenkontaktierungen (3) bereitgestellt (Figur 1).
b) Die Seite C des Bauteils wird in ein Galvanotechnik-Beschichtungsbecken getaucht, die Innenelektroden (2) werden über die Außenkontaktierung (3) auf der Seite B des Piezostapels (1) auf negatives Potential gesetzt. An den nun spannungsführenden Innenelektroden (2) (Kathoden) wird eine mehrere µm dicke Metallschicht (typischerweise 10 bis 20 µm) abgeschieden (Galvanotechnikprozess).
c) Nun wird für die Seite A der Verfahrensschritt b) analog wiederholt.
d) Die strukturierte Oberfläche des Piezostapels (1) (vgl. Figur 5A) wird nun mit Isolationsmaterial (8) geglättet (vgl. Figur 5B). Vorzugsweise wird als Isolationsmaterial Glas oder organischer Lack verwendet.
e) Die Oberfläche A und C des Riegels werden poliert, so dass die galvanisierten nach außen stehenden Elektroden (7) für eine weitere Metallisierung hinreichend frei und geeignet sind (z. B. Spattern, Überschleifen, etc.). Die tiefer liegenden Elektroden bleiben durch diesen Reinigungsschritt weiterhin von der Oberfläche isoliert.
f) Nun wird eine Außenmetallisierung auf Seiten A und C aufgebracht, der Piezostapel zu vollaktiven Piezostapeln vereinzelt und weiter verarbeitet.

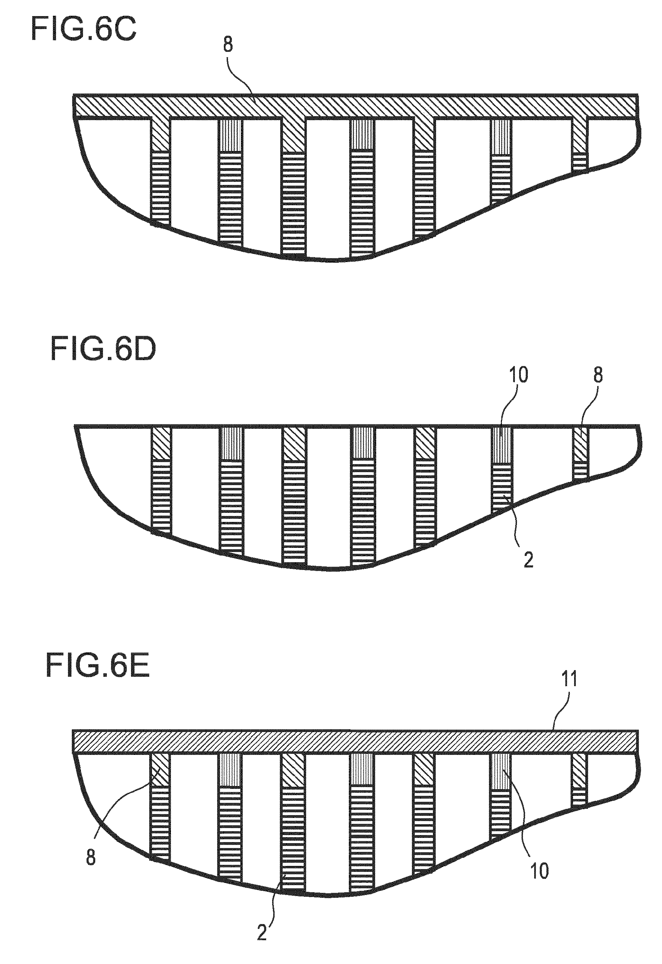

In einem dritten Ausführungsbeispiel ist der Prozessablauf wie folgt (vgl. Figuren 6A bis 6E):
a) Es wird ein gesinterter Piezostapel (1) mit seitlichen (temporären) Isozonen und Außenkontaktierungen (3) bereitgestellt (Figur 1).
b) Der Piezostapel (1) wird einseitig (Seite C) in eine geeignete Elektrolytlösung getaucht (Figur 2), der Piezostapel (1) an den Innenelektroden (2) über die Außenkontaktierung (3) auf der Seite B und gleichzeitig über die nicht gezeigte Außenelektrode (3') auf der Seite D die Innenelektroden (2') unter (positive) Spannung gesetzt, die Gegenelektrode (5) auf negative Spannung, und ein paar Minuten bestromt. Alle Elektroden werden dadurch durch das Prinzip des elektrochemischen Abtragens um 1 bis 10 µm, vorzugsweise 1 bis 5 µm, zurückgeätzt.
c) Anschließend wird die Seite C des Piezostapels (1) in ein Galvanotechnik-Beschichtungsbecken getaucht und die Innenelektroden (2) über die Außenkontaktierung (3) auf der Seite B des Piezostapels (1) auf negatives Potential gesetzt. An den nun spannungsführenden Innenelektroden (2) (Kathoden) werden die geätzten Gräben (9) wieder mit leitfähigem Material aufgefüllt.
d) Nun werden für die Seite A die Verfahrensschritte b) und c) analog wiederholt.
e) Die Gräben (9) werden nun mit isolierendem Material gefüllt (z.B. verglast, oder mit organischem Lack versiegelt).
f) Die Oberflächen A und C des Piezostapels (1) werden so gereinigt, dass Oberflächen der nach außen stehenden Elektroden für eine weitere Metallisierung hinreichend frei und geeignet sind (z. B. Sputtern, Überschleifen, etc.). Die tiefer liegenden Elektroden bleiben durch diesen Reinigungsschritt weiterhin von der Oberfläche isoliert.
g) Nun wird eine Außenmetallisierung auf den Seiten A und C aufgebracht, der Piezostapel (1) zu vollaktiven Piezostapeln (12) vereinzelt und weiter verarbeitet.

In einem vierten Ausführungsbeispiel ist der Prozessablauf wie folgt:
a) Es wird ein gesinterter Piezostapel (1) mit seitlichen (temporären) Isozonen und Außenkontaktierungen (3) bereitgestellt (Abbildung 1).
b) Der Piezostapel (1) wird mit der Seite C in ein Elektrolysebad getaucht und die Innenelektroden (2) werden über die Außenkontaktierung (3) auf der Seite B unter Spannung gesetzt und es wird nach dem Prinzip des elektrochemischen Rückätzens 1 bis 10 µm, vorzugsweise 1 bis 5 µm, zurückgeätzt.
c) Anschließend wird die Seite C des Bauteils in ein Galvanotechnik-Beschichtungsbecken getaucht, die Innenelektroden (2) über die Außenkontaktierung (3) auf der Seite B des Piezostapels (1) auf negative Spannung gesetzt. An den nun spannungsführenden Innenelektroden (2) (Kathoden) wird eine mehrere µm dicke Metallschicht, vorzugsweise über den Ätzkanal hinaus, abgeschieden (Galvanotechnikprozess). Vorzugsweise wird hier ein Material verwendet, das sich von dem Material der Innenelektrode (2) unterscheidet. Weiter bevorzugt wird ein Metall oder eine Metallmischung verwendet, die unedler ist als das Metall der Innenelektrode. Z. B. kann Aluminium verwendet werden.
d) Anschließend wird die galvanische Beschichtung auf der Seite C durch anodische Oxidation oxidiert. Auf diese Weise kann eine besonders wirksame Isolierung hergestellt werden.
e) Die Schritte b) bis d) werden für die Seite A des Riegels in analoger Weise wiederholt.
f) Das Bauteil wird vereinzelt.
g) Nun wird eine Außenmetallisierung auf den Seiten A und C aufgebracht.

Die Schritte f) und g) können auch in umgekehrter Reihenfolge durchgeführt werden.

In einem fünften Ausführungsbeispiel ist der Prozessablauf wie folgt:
a) Es wird ein gesinterter Piezostapel (1) mit seitlichen (temporären) Isozonen und Außenkontaktierungen (3) bereitgestellt (Figur 1).
b) Die Seite C des Piezostapels (1) wird in ein Galvanotechnik-Beschichtungsbecken getaucht und die Innenelektroden (2) über die Außenkontaktierung (3) auf der Seite B des Piezostapels (1) auf negatives Potential gesetzt. An den nun spannungsführenden Innenelektroden (2) (Kathoden) wird eine mehrere µm dicke Metallschicht (typischerweise 10 bis 20 µm) abgeschieden (Galvanotechnik-Prozess).
c) Anschließend wird die galvanische Beschichtung durch anodische Oxidation in eine Oxidbeschichtung umgewandelt.
d) Nun werden für die Seite A die Verfahrensschritte b) und c) analog wiederholt.
e) Das Bauteil wird vereinzelt (Abbildung 4).
f) Es wird eine Außenmetallisierung auf den Seiten A und C aufgebracht.

Die Schritte e) und f) können auch in umgekehrter Reihenfolge prozessiert werden.

In einem sechsten Ausführungsbeispiel ist der Prozessablauf wie folgt:
a) Es wird ein grüner Piezostapel (1) mit seitlichen (temporären) Isozonen und Außenkontaktierungen (3) bereitgestellt (Figur 1).
b) Der Piezostapel (1) wird einseitig (Seite C) in eine geeignete Elektrolytlösung getaucht und die Innenelektroden (2) über die Außenkontaktierung (3) auf den Seiten B und D unter (positive) Spannung gesetzt und die Gegenelektrode auf positive Spannung, und einige Minuten bestromt. Hierdurch werden alle Innenelektroden (2, 2') nach dem Prinzip des elektrochemischen Abtragens zurückgeätzt.
c) Anschließend wird die Seite C des Bauteils in ein Galvanotechnik-Beschichtungsbecken getaucht, die Innenelektroden (2) über die Außenkontaktierung (3) des Piezostapels (1) auf positives Potential gesetzt. An den nun spannungsführenden Innenelektroden (2) (Anoden) werden die geätzten Gräben (9) wieder mit leitfähigem Material aufgefüllt.
d) Nun werden für die Seite A die Verfahrensschritte b) und c) analog wiederholt.
e) Der grüne Piezostapel (1) wird gesintert, wobei die nicht aufgefüllten Gräben (9) zugesintert werden.
f) Die Oberflächen A und C des Piezostapels (1) werden gereinigt, so dass die Oberflächen der galvanisierten Innenelektroden (2) für eine weitere Metallisierung hinreichend frei und geeignet sind (z. B. Sputtern, Überschleifen, etc.). Die tiefer liegenden Innenelektroden (2') bleiben durch diesen Reinigungsschritt weiterhin von der Oberfläche isoliert.
g) Nun wird eine Außenmetallisierung auf den Seiten A und C angebracht, der gesinterte Piezostapel (1) zu vollaktiven Piezostapeln (12) vereinzelt und weiter verarbeitet.

### Bezugszeichenliste

- A, B, C, D: Seiten des Piezostapels in Stapelrichtung
- 1: Piezostapel
- 2, 2': Innenelektroden
- 3: Außenkontaktierung mit temporären Isozonen
- 4: Oxidschicht über Innenelektroden
- 5: Gegenelektrode
- 6: Elektrolytlösung
- 7: galvanische Beschichtung
- 8: Isolationsmaterial
- 9: elektrochemisch zurückgeätzte Gräben
- 10: galvanisch gefüllte Gräben
- 11: Außenelektrode
- 12: vollaktiver Piezostapel

## Patentansprüche

1. Verfahren zur Herstellung eines vollaktiven Stapels oder dessen grünem Vorläufer, umfassend:
- Bereitstellen eines gesinterten oder ungesinterten Stapels (1) mit den jeweils in Stapelrichtung verlaufenden Seiten A, B, C und D aus mehreren abwechselnd aufeinanderfolgenden keramischen dielektrischen Schichten und Innenelektrodenschichten (2, 2'), wobei die Innenelektrodenschichten (2, 2') bezüglich der Seiten A und C jeweils durchgehend ausgebildet sind und bezüglich entweder der Seite B oder der Seite D jeweils nicht durchgehend ausgebildet sind, so dass ein Teil der Innenelektroden (2) oder deren ungesinterte Vorläufer die Seite B, nicht aber die Seite D, kontaktiert und ein anderer Teil der Innenelektroden (2') oder deren ungesinterte Vorläufer die Seite D, nicht aber die Seite B, kontaktiert;
- Zusammenfassen und temporäres Kontaktieren der die jeweilige Seite kontaktierenden Innenelektroden (2, 2') oder deren ungesinterte Vorläufer auf einer der Seiten B oder D über einen Außenkontakt mit temporären Isozonen (3), so dass die die jeweilige Seite kontaktierenden Innenelektroden selektiv elektrisch angesteuert werden können;
- elektrochemisches Beschichten der elektrisch angesteuerten Innenelektroden oder deren ungesinterte Vorläufer auf den Seiten A und C,
- Vereinzeln des Stapels zu einem vollaktiven Stapel oder dessen grünem Vorläufer mit den elektrochemisch beschichteten Innenelektroden oder deren ungesinterte Vorläufer auf den Seiten A' und C', **gekennzeichnet dadurch, dass** das elektrochemische Beschichten mittels Galvanotechnik erfolgt und nach dem elektrochemischen Beschichten mittels Galvanotechnik die Beschichtung durch elektrochemische Oxidation in eine isolierende Oxidbeschichtung umgewandelt wird.

2. Verfahren nach Anspruch 1, wobei der Stapel (1) Bereiche umfasst, worin die Innenelektrodenschichten (2, 2') die Seiten A und D jeweils abwechselnd kontaktieren.

3. Verfahren nach einem der vorhergehenden Ansprüche, wobei das elektrochemische Beschichten mittels elektrochemischer Oxidation, vorzugsweise durch anodische Oxidation, erfolgt.

4. Verfahren nach einem der vorhergehenden Ansprüche, wobei vor dem elektrochemischen Beschichten mindestens ein Teil der Innenelektroden (2, 2'), vorzugsweise nach dem Prinzip des elektrochemischen Abtragens, zurückgeätzt werden.

5. Verfahren nach einem der vorhergehenden Ansprüche, wobei nach dem elektrochemischen Beschichten mittels Galvanotechnik die unbeschichteten Innenelektroden mit Isoliermaterial abgedeckt werden.

6. Verfahren nach einem der vorhergehenden Ansprüche, wobei nach dem elektrochemischen Beschichten mittels Galvanotechnik die Beschichtung durch anodische Oxidation in eine isolierende Oxidbeschichtung umgewandelt wird.

7. Verfahren nach einem der vorhergehenden Ansprüche, wobei das elektrochemische Beschichten mittels Galvanotechnik durchgeführt wird und als galvanisches Beschichtungsmaterial ein Metall oder eine Metallmischung verwendet wird, das sich von dem Metall der Innenelektrode unterscheidet, vorzugsweise unedler ist.

8. Verfahren nach einem der vorhergehenden Ansprüche, wobei vor dem elektrochemischen Beschichten mindestens ein Teil der Innenelektroden (2, 2'), vorzugsweise nach dem Prinzip des electrochemischen Abtragens, zurückgeätzt werden und die nach dem Zurückätzen nicht wieder aufgefüllten Gräben durch Sintern verschlossen werden.

9. Verfahren nach einem der vorhergehenden Ansprüche, wobei das elektrochemische Beschichten in einer wässrigen NaCl-Lösung als Elektrolyt, vorzugsweise unter Wechselspannung, durchgeführt wird.

10. Verfahren nach einem der vorhergehenden Ansprüche, wobei die Innenelektrodenschichten Silber, eine Silberlegierung, vorzugsweise AgPd, oder Kupfer umfassen.

11. Verfahren zur Herstellung eines vollaktiven Vielschichtbauelements umfassend:
- Herstellen eines vollaktiven Stapels (12) nach einem der Ansprüche 1 bis 9 und gegebenenfalls Sintern des vollaktiven Stapels oder dessen grünen Vorläufers;
- Aufbringen von Außenelektroden auf den Seiten A' und C' des vollaktiven Stapels (12) und Kontaktieren der elektrochemisch beschichteten oder unbeschichteten Innenelektroden, so dass die beiden Außenelektroden (11) entweder mit den elektrochemisch beschichteten oder den elektrochemisch unbeschichteten Innenelektrodenschichten (2, 2') elektrisch verbunden sind.

12. Vollaktives Vielschichtbauelement umfassend einen vollaktiven Stapel (12) aus mehreren dielektrischen Schichten und Innenelektrodenschichten (2, 2') und zwei auf gegenüberliegenden Seiten des Stapels angeordneten Außenelektroden (11), wobei mindestens ein Teil der Innenelektrodenschichten (2, 2') elektrochemisch beschichtet sind, wobei die beiden Außenelektroden (11) jeweils entweder mit den elektrochemisch beschichteten oder den elektrochemisch unbeschichteten Innenelektroden (2, 2') elektrisch verbunden sind und wobei die elektrische Verbindung zu einem Teil der Innenelektroden (2,2') über eine Oxidschicht (4) auf den Innenelektroden unterbrochen ist, **gekennzeichnet dadurch, dass** die Oxidschicht (4) ein Metall enthält, das sich von dem in den Innenelektroden (2, 2') enthaltenem Metall unterscheidet.

13. Vielschichtbauelement nach Anspruch 12, wobei die Oxidschicht (4) ein Metall enthält, das unedler ist als ein in den Innenelektroden (2, 2') verwendetes Metall.

## Claims

1. Method for producing a fully active stack or the green precursor thereof, comprising:
- providing a sintered or unsintered stack (1) having the sides A, B, C and D running in each case in the stacking direction, comprising a plurality of alternately successive ceramic dielectric layers and internal electrode layers (2, 2'), wherein the internal electrode layers (2, 2') are embodied in each case in a continuous fashion with respect to the sides A and C and are embodied in each case in a non-continuous fashion with respect to either the side B or the side D, such that one portion of the internal electrodes (2) or the unsintered precursors thereof make contact with the side B, but not with the side D, and another portion of the internal electrodes (2') or the unsintered precursors thereof make contact with the side D, but not with the side B;
- combining and temporarily making contact with the internal electrodes (2, 2') that make contact with the respective side or the unsintered precursors of said internal electrodes on one of the sides B or D via an external contact with temporary isozones (3), such that the internal electrodes that make contact with the respective side can be electrically driven selectively;
- electrochemically coating the electrically driven internal electrodes or the unsintered precursors thereof on the sides A and C,
- singulating the stack to form a fully active stack or the green precursor thereof with the electrochemically coated internal electrodes or the unsintered precursors thereof on the sides A' and C' **characterized in that** the process of electrochemical coating is effected by means of plating technology and after the process of electrochemical coating by means of plating technology the coating is converted into an insulating oxide coating by electrochemical oxidation.

2. Method according to Claim 1, wherein the stack (1) comprises regions in which the internal electrode layers (2, 2') make contact with the sides A and D alternately in each case.

3. Method according to either of the preceding claims, wherein the process of electrochemical coating is effected by means of electrochemical oxidation, preferably by anodic oxidation.

4. Method according to any of the preceding claims, wherein before the process of electrochemical coating at least one portion of the internal electrodes (2, 2') are etched back, preferably according to the principle of electrochemical machining.

5. Method according to any of the preceding claims, wherein after the process of electrochemical coating by means of plating technology the uncoated internal electrodes are covered with insulating material.

6. Method according to any of the preceding claims, wherein after the process of electrochemical coating by means of plating technology the coating is converted into an insulating oxide coating by anodic oxidation.

7. Method according to any of the preceding claims, wherein the process of electrochemical coating is carried out by means of plating technology and a metal or a metal mixture which differs from the metal of the internal electrode, preferably by being more electronegative, is used as electrolytic coating material.

8. Method according to any of the preceding claims, wherein before the process of electrochemical coating at least one portion of the internal electrodes (2, 2') are etched back, preferably according to the principle of electrochemical machining, and the trenches that are not filled again after the etching-back process are closed by sintering.

9. Method according to any of the preceding claims, wherein the process of electrochemical coating is carried out in an aqueous NaCl solution as electrolyte, preferably under AC voltage.

10. Method according to any of the preceding claims, wherein the internal electrode layers comprise silver, a silver alloy, preferably AgPd, or copper.

11. Method for producing a fully active multilayer component comprising:
- producing a fully active stack (12) according to any of Claims 1 to 9 and, if appropriate, sintering the fully active stack or the green precursor thereof;
- applying external electrodes on the sides A' and C' of the fully active stack (12) and making contact with the electrochemically coated or uncoated internal electrodes, such that the two external electrodes (11) are electrically connected either to the electrochemically coated or to the electrochemically uncoated internal electrode layers (2, 2').

12. Fully active multilayer component comprising a fully active stack (12) comprising a plurality of dielectric layers and internal electrode layers (2, 2') and two external electrodes (11) arranged on opposite sides of the stack, wherein at least one portion of the internal electrode layers (2, 2') are electrochemically coated, wherein the two external electrodes (11) are electrically connected in each case either to the electrochemically coated or to the electrochemically uncoated internal electrodes (2, 2'), and wherein the electrical connection to a portion of the internal electrodes (2, 2') is interrupted by means of an oxide layer (4) on the internal electrodes, **characterized in that** the oxide layer (4) contains a metal which differs from the metal contained in the internal electrodes (2, 2').

13. Multilayer component according to Claim 12, wherein the oxide layer (4) contains a metal which is more electronegative than a metal used in the internal electrodes (2, 2').

## Revendications

1. Procédé de production d'un empilement pleinement actif ou de son précurseur vert, comprenant:
- préparation d'un empilement (1) fritté ou non fritté avec les côtés A, B, C et D s'étendant respectivement dans la direction d'empilement à partir de plusieurs couches céramiques diélectriques et de couches d'électrodes intérieures se succédant en alternance (2, 2'), dans lequel les couches d'électrodes intérieures (2, 2') sont respectivement ininterrompues par rapport aux côtés A et C et ne sont pas ininterrompues par rapport ni au côté B ni au côté D respectivement, de telle manière qu'une partie des électrodes intérieures (2) ou de leurs précurseurs non frittés contacte le côté B, mais pas le côté D, et qu'une autre partie des électrodes intérieures (2') ou de leurs précurseurs non frittés contacte le côté D, mais pas le côté B;
- réunion et mise en contact temporaire des électrodes intérieures (2, 2') ou de leurs précurseurs non frittés contactant le côté respectif sur un des côtés B ou D au moyen d'un contact extérieur avec des isozones temporaires (3), de telle manière que les électrodes intérieures contactant le côté respectif puissent être activées électriquement de façon sélective;
- revêtement électrochimique des électrodes intérieures activées électriquement ou de leurs précurseurs non frittés sur les côtés A et C,
- séparation de l'empilement en un empilement pleinement actif ou en son précurseur vert avec les électrodes intérieures revêtues par voie électrochimique ou de leurs précurseurs non frittés sur les côtés A' et C',
**caractérisé en ce que** le revêtement électrochimique est effectué par galvanotechnique et, après le revêtement électrochimique par galvanotechnique, on convertit le revêtement par oxydation électrochimique en un revêtement d'oxyde isolant.

2. Procédé selon la revendication 1, dans lequel l'empilement (1) comprend des régions, dans lesquelles les couches d'électrodes intérieures (2, 2') contactent en alternance respectivement les côtés A et D.

3. Procédé selon l'une quelconque des revendications précédentes, dans lequel le revêtement électrochimique est effectué au moyen d'une oxydation électrochimique, de préférence par oxydation anodique.

4. Procédé selon l'une quelconque des revendications précédentes, dans lequel au moins une partie des électrodes intérieures (2, 2') est décapée, de préférence selon le principe de l'enlèvement de matière électrochimique, avant le revêtement électrochimique.

5. Procédé selon l'une quelconque des revendications précédentes, dans lequel on recouvre les électrodes intérieures non revêtues avec un matériau isolant après le revêtement électrochimique par galvanotechnique.

6. Procédé selon l'une quelconque des revendications précédentes, dans lequel on convertit le revêtement par oxydation anodique en un revêtement d'oxyde isolant après le revêtement électrochimique par galvanotechnique.

7. Procédé selon l'une quelconque des revendications précédentes, dans lequel on effectue le revêtement électrochimique par galvanotechnique et on utilise comme matériau de revêtement galvanique un métal ou un mélange de métaux, qui diffère du métal de l'électrode intérieure, de préférence est moins noble.

8. Procédé selon l'une quelconque des revendications précédentes, dans lequel on décape, avant le revêtement électrochimique, au moins une partie des électrodes intérieures (2, 2'), de préférence selon le principe de l'enlèvement de matière électrochimique, et on ferme par frittage les cratères qui ne sont pas de nouveau remplis après le décapage.

9. Procédé selon l'une quelconque des revendications précédentes, dans lequel on effectue le revêtement électrochimique dans une solution aqueuse de NaCl comme électrolyte, de préférence sous une tension alternative.

10. Procédé selon l'une quelconque des revendications précédentes, dans lequel les électrodes intérieures comprennent de l'argent, un alliage d'argent, de préférence AgPd, ou du cuivre.

11. Procédé de production d'un composant multicouche pleinement actif, comprenant:
- la production d'un empilement pleinement actif (12) selon l'une quelconque des revendications 1 à 9 et éventuellement frittage de l'empilement pleinement actif ou de son précurseur vert;
- pose d'électrodes extérieures sur les côtés A' et C' de l'empilement pleinement actif (12) et mise en contact des électrodes intérieures revêtues ou non revêtues par voie électrochimique, de telle manière que les deux électrodes extérieures (11) soient reliées électriquement aux couches d'électrodes intérieures (2, 2') soit revêtues par voie électrochimique soit non revêtues par voie électrochimiques.

12. Composant multicouche pleinement actif comprenant un empilement pleinement actif (12) constitué de plusieurs couches diélectriques et de plusieurs couches d'électrodes intérieures (2, 2') et de deux électrodes extérieures (11) disposées sur des côtés opposés de l'empilement, dans lequel au moins une partie des couches d'électrodes intérieures (2, 2') sont revêtues par voie électrochimique, dans lequel les deux électrodes extérieures (11) sont électriquement reliées respectivement aux couches d'électrodes intérieures (2, 2') soit revêtues par voie électrochimique soit non revêtues par voie électrochimique, et dans lequel la liaison électrique à une partie des électrodes intérieures (2, 2') est interrompue par une couche d'oxyde (4) sur les électrodes intérieures, **caractérisé en ce que** la couche d'oxyde (4) contient un métal, qui est différent du métal contenu dans les électrodes intérieures (2, 2').

13. Composant multicouche selon la revendication 12, dans lequel la couche d'oxyde (4) contient un métal qui est moins noble qu'un métal utilisé dans les électrodes intérieures (2, 2').
